# DEMANDE DE BREVET EUROPEEN

(11) **EP 2 521 183 A2**
(43) Date de publication de la demande: **07.11.2012**
(21) Numéro de dépôt: 12166647.3
(22) Date de dépôt: 03.05.2012
(51) Int. Cl.: H01L 31/0224, H01L 31/0296

(54) **Cellule photovoltaïque incorporant une couche tampon d'oxyde(s) de zinc et d'etain**

(30) Priorité: 06.05.2011 FR 1153925
(71) Demandeur: Saint-Gobain Glass France, 92400 Courbevoie (FR)
(72) Inventeur: Charlet, Emilie, 75011 Paris (FR); Bonnet-Eymard, Maximilien M., 78150 Le Chesnay (FR)
(74) Mandataire: Lucas, Francois

(57) **Abrégé**

Cellule photovoltaïque (100) comprenant au moins un substrat transparent de face avant (10) notamment verrier, protégeant un empilement de couches (30) comprenant un film à propriétés photovoltaïques (5) incorporant de préférence au moins un matériau comprenant du Cadmium et deux électrodes inférieure (3) et supérieure (6), disposées de part et d'autre dudit film photovoltaïque (5), l'électrode inférieure (3), c'est-à-dire la plus proche du substrat de face avant (10), étant constituée par un revêtement du type oxyde transparent conducteur TCO, ladite cellule se caractérisant en ce qu'une couche tampon est interposée entre ledit TCO et ledit film photovoltaïque, ladite couche étant constituée par un oxyde ou par un mélange d'oxydes de zinc et d'étain, le rapport molaire Sn/Zn dans ladite couche étant compris entre 60/40 et 85/15.

## Description

L'invention concerne une nouvelle cellule photovoltaïque, comprenant notamment un substrat verrier revêtu d'une couche transparente d'oxyde électriquement conducteur, souvent appelé TCO dans le domaine.
On entend dans la suite de la description par substrat verrier un substrat en verre minéral.

De façon connue, un module photovoltaïque est constitué d'un ensemble de cellules photovoltaïques souvent couplées en série les unes aux autres. Ces cellules génèrent un courant continu lorsqu'elles sont exposées à la lumière. Pour fournir une puissance adaptée qui correspond à une énergie suffisante et attendue, on réalise des surfaces suffisamment étendues d'une multitude de modules photovoltaïques. Ces modules peuvent être intégrés sur les toits des habitations ou des locaux commerciaux ou disposés dans des champs pour la production d'énergie centralisée. Diverses technologies existent dans la réalisation des cellules photovoltaïques. Les cellules les plus répandues sont à base de semi-conducteurs, en particulier de semi-conducteurs en silicium cristallin ou de semi-conducteurs en couches minces.

Classiquement, un module photovoltaïque comprend ainsi un substrat servant de support et un matériau dit photovoltaïque qui est le plus souvent constitué d'un empilement de semi-conducteurs dopés N et P, formant dans leur zone de contact électrique une jonction p-n. Un autre substrat, sur la face opposée, assure la protection du matériau photovoltaïque. Parmi ces deux substrats, on dénomme substrat avant ou substrat de face avant celui qui est destiné à être en regard de l'énergie lumineuse reçue. Ce substrat de face avant est de préférence un verre minéral transparent présentant une transmission lumineuse très élevée dans la gamme de rayonnement 300 à 1250 nm. Il est avantageusement traité thermiquement (c'est-à-dire recuit, trempé ou durci) pour pouvoir résister aux intempéries, en particulier la grêle, et cela de manière durable dans le temps (25 à 30 ans). De chaque coté du matériau photovoltaïque sont disposées des électrodes constituées par des matériaux électriquement conducteurs qui constituent les bornes positives et négatives de la cellule photovoltaïque. De façon connue, les deux électrodes (anode et cathode) du module photovoltaïque permettent de collecter le courant produit sous l'effet de la lumière dans le matériau photovoltaïque, le transport et la ségrégation des charges étant dus à la différence de potentiel créée entre les parties respectivement dopée p et n des semi-conducteurs. Un exemple d'un tel module est par exemple décrit dans la demande WO2006/005889, à laquelle on se référera pour les détails de la réalisation.

Si le silicium cristallin offre en tant que semi-conducteur un bon rendement énergétique, et constitue la première génération des cellules photovoltaïques sous forme de « Wafers », on s'intéresse de plus en plus dans l'industrie aux technologies dites « couches minces ».

Selon cette technologie, le matériau siège de l'activité photovoltaïque, comprenant ou constitué de silicium amorphe (a-Si) ou microcristallin (µc-Si), ou encore de tellure de cadmium (CdTe, notamment dans une hétérojonction CdS/CdTe) ou encore de séléniures (CIS, CIGS, CiGSe₂), est cette fois directement déposé sur le substrat sous la forme de couches plus ou moins épaisses.

Par exemple, un dispositif de cellule photovoltaïque à hétérojonction CdTe/CdS ayant une efficacité de conversion entre l'énergie lumineuse reçue et l'énergie électrique obtenue de l'ordre de 9% peut être obtenu. En outre, l'épaisseur cependant réduite de ces matériaux déposés en couche mince offre théoriquement la possibilité de réduire les coûts de production des cellules. La fabrication de modules sur des substrats verriers, découpés à la taille finale des modules, comporte ainsi le dépôt d'une succession de couches minces déposées et formées directement en succession sur le substrat, dont au moins :
- une couche servant d'électrode avant transparente au rayonnement incident,
- les différentes couches minces constituant le matériau photovoltaïque lui-même et
- une couche mince servant d'électrode arrière réfléchissante.

Les cellules photovoltaïques, quant à leur taille et aux connexions électriques à établir entre elles, sont réalisées par des étapes tampons de gravure par laser entre chaque étape de dépôt de couche. Ces substrats verriers, souvent trempés et intégrant les cellules photovoltaïques constituent ainsi les substrats de face avant des modules. Un substrat support de face arrière est en général ensuite rapporté par feuilletage contre la face pourvue de l'empilement de couches du substrat de face avant.

L'électrode agencée contre le substrat en verre de face avant du module est bien entendu transparente pour laisser passer l'énergie lumineuse jusqu'à l'absorbeur. Cette électrode comporte le plus souvent un oxyde transparent électro-conducteur (appelée souvent dans le domaine TCO pour « Transparent Conductive Oxide »).

De façon connue, on utilise le plus souvent comme matériau, pour la fabrication de ces couches TCO, des couches fines en oxyde de zinc dopé à l'aluminium, (AZO), en oxyde d'étain dopé à l'Indium (ITO), en oxyde d'étain dopé au fluor (SnO2 :F) ou encore en oxyde de zinc dopé au gallium (GZO) ou en oxyde de zinc dopé au bore (BZO).

Il faut bien noter que ces couches constituant les électrodes, notamment celles disposées en face avant, c'est-à-dire à proximité du substrat avant, sont des composants fonctionnels essentiels des cellules solaires en couche mince, car elles servent à évacuer vers la cathode les électrons ou trous formés par le rayonnement électromagnétique incident dans la couche semi-conductrice photovoltaïque. A ce titre, il est nécessaire pour l'application que leur résistivité soit la plus faible possible. Notamment, pour obtenir la conduction électrique souhaitée, ou plutôt la faible résistance souhaitée, le revêtement électrode à base de TCO doit être déposé à une épaisseur physique relativement importante, de l'ordre de quelques centaines de nanomètres, ce qui coûte cher eu égard au prix de ces matériaux lorsqu'ils sont déposés en couches minces, notamment par la technique de pulvérisation magnétron. L'inconvénient majeur des revêtements électrodes à base de TCO réside ainsi tout particulièrement dans le fait que l'épaisseur physique du matériau est nécessairement un compromis entre sa conduction électrique finale et sa transparence finale après le dépôt. Autrement dit, plus l'épaisseur physique du matériau est importante, plus sa conductivité sera forte mais plus la transparence sera faible et inversement. Au final, il n'est donc pas possible avec les revêtements TCO actuels d'optimiser indépendamment et de façon satisfaisante la conductivité du revêtement électrode et sa transparence.

Dans la suite de la description et dans les revendications, on désigne par les termes « inférieur » et « supérieur » les positions respectives des couches les unes par rapport aux autres et par référence au substrat verrier de face avant.

De même, on désigne comme sur-couche une couche disposée au dessus de la couche d'électrode (TCO) par référence au substrat verrier de face avant et comme sous-couche une couche disposée au dessous de la couche d'électrode (TCO) par rapport au substrat verrier de face avant, sans qu'il y ait nécessairement contact entre les deux couches.

Un autre problème de ces TCO provient de leur utilisation dans l'application spécifique en tant qu'électrode dans un module photovoltaïque : pour conférer au substrat verrier sa résistance mécanique, les substrats revêtus de la couche TCO doivent souvent subir un traitement thermique final, notamment une trempe. De même, il est souvent nécessaire de chauffer la couche TCO pour en augmenter la cristallinité et par suite la conductivité et la transparence. De plus, le dépôt de certaines couches photovoltaïques telles que les couches incorporant du Cadmium, notamment de CdTe, nécessite une température de mise en oeuvre d'au moins 400°C, et même jusqu'à 700°C. La meilleure efficacité de la couche CdTe ne peut cependant être obtenue qu'après un traitement thermique supplémentaire sous une atmosphère de Chlorure de Cadmium, à des températures proches ou supérieures à 400°C. Pendant les trempes et/ou les chauffages successifs, l'empilement est ainsi porté, sous atmosphère ambiante ou autre, à des températures parfois supérieures à 500 degrés, voire supérieures à 600°C, pendant quelques minutes. Lors de ces traitements thermiques, après une première phase de diminution de leur résistivité électrique (ou encore de leur R/carré), la plupart des TCO voient au contraire leurs propriétés électriques se dégrader drastiquement si le traitement thermique est prolongé au delà de quelques minutes. Sans que cela puisse être considéré comme une affirmation définitive, un tel phénomène s'expliquerait d'une part en raison de la migration des alcalins du verre par la surface de la couche TCO au regard du substrat et d'autre part par l'oxydation du TCO par l'oxygène contenu dans le four selon l'autre surface. Des solutions existantes (décrites par exemple dans WO2007018951 ou US20070029186) proposent d'encapsuler le TCO dans des couches barrières inférieures et supérieures, le protégeant ainsi de la migration des alcalins (par la sous-couche) et de l'oxydation (par la sur-couche). Cependant, ces couches barrières permettent de modérer la dégradation du TCO pendant la trempe mais pas de l'améliorer.

Dans le cas spécifique des cellules photovoltaïques comprenant une hétérojonction du type CdS/CdTe, le brevet US 6,169,246 B1, pour améliorer les propriétés des couches photovoltaïques, recommande d'utiliser une couche en stannate de zinc de formulation Zn₂SnO₄, dite tampon, entre la couche de TCO et le film photovoltaïque CdS/CdTe.

La présente invention vise à améliorer encore les techniques précédentes, et notamment celle décrite dans le brevet précédent, en proposant une solution améliorée conduisant à l'obtention d'une cellule photovoltaïque d'efficacité améliorée.

Tout particulièrement, la présente invention propose une structure de cellule photovoltaïque qui permette d'améliorer le contact électrique entre le film photovoltaïque comprenant du Cadmium comme le CdS et la couche de TCO, de telle manière que l'efficacité totale de conversion de l'énergie solaire de l'ensemble de la cellule photovoltaïque soit améliorée.

Plus particulièrement, la présente invention se rapporte à une cellule photovoltaïque comprenant au moins un substrat transparent de face avant notamment verrier, protégeant un empilement de couches comprenant un film à propriétés photovoltaïques et deux électrodes inférieure et supérieure, disposées de part et d'autre dudit film photovoltaïque, l'électrode inférieure, c'est-à-dire la plus proche du substrat de face avant, étant constituée par un revêtement du type oxyde transparent conducteur TCO, ladite cellule se caractérisant :
a) en ce que ledit oxyde transparent conducteur est un oxyde de zinc dopé par au moins un élément choisi parmi Al, Ga, In, B, Ti, V, Y, Zr,
b) en ce qu'une couche tampon est interposée entre ledit TCO et ledit film photovoltaïque, ladite couche tampon présentant les caractéristiques suivantes :
   - elle est constituée par un oxyde ou par un mélange d'oxydes de zinc et d'étain dans lequel le rapport molaire Sn/Zn est compris entre 60/40 et 85/15,
   - elle présente une épaisseur comprise entre 150 et 200 nm,

Selon différents modes avantageux de la présente invention, qui peuvent bien évidemment être combinés entre eux :
- La couche tampon constituée par un oxyde ou par un mélange d'oxyde présente un rapport molaire Sn/Zn compris entre 70/30 et 85/15.
- La couche tampon constituée par un oxyde ou par un mélange d'oxyde présente un rapport molaire Sn/Zn compris entre 65/35 et 80/20.
- Le film photovoltaïque comprend du Cadmium et en particulier comprend une hétérojonction du type CdS/CdTe.
- Le film photovoltaïque comprend un séléniure, notamment de cuivre et d'indium (CIS) ou de cuivre, d'indium et de gallium (CIGS).
- Ledit oxyde transparent conducteur TCO est l'oxyde de zinc dopé à l'aluminium, au gallium ou au bore, de préférence l'oxyde de zinc dopé à l'aluminium.
- La couche de TCO présente une épaisseur comprise entre 50 et 1600 nm, notamment entre 500 et 1500nm.
- Une couche de nitrure de gallium ou d'aluminium est présente entre ladite couche TCO et ladite couche tampon.
- La couche tampon est déposée par les techniques de pulvérisation magnétique magnétron à partir d'une cible métallique comprenant un alliage de zinc et d'étain dans une atmosphère contenant de l'oxygène.
- La couche tampon est déposée par les techniques de co-pulvérisation magnétique magnétron d'une cible en zinc métallique et d'une cible en étain métallique, dans une atmosphère contenant de l'oxygène.

Une cellule photovoltaïque selon la présente invention comprend notamment:
- un premier substrat verrier, dont la transmission lumineuse dans la gamme de longueur d'onde de 300 à 1 250 nm est supérieure à 75%, de préférence supérieure à 85%,
- un empilement comprenant au moins, en succession depuis la surface dudit premier substrat verrier :
   o une couche d'oxyde transparent conducteur en oxyde de zinc dopé à l'aluminium, au gallium ou au bore,
   o une couche tampon constituée par un oxyde ou un mélange d'oxyde dans laquelle le rapport molaire Sn/Zn est compris entre 60/40 et 85/15, de préférence entre 70/30 et 85/15, ou encore entre 70/30 et 85/15,
   o un film photovoltaïque de préférence comprenant du cadmium ou du sélénium, en particulier incorporant une jonction hétérogène du type CdS/CdTe,
   o une couche conductrice transparente du type TCO ou non transparente, en molybdène ou en un autre matériau métallique du type argent, cuivre, aluminium, molybdène,
- un second substrat verrier, collé au premier substrat, revêtu de l'empilement, par un intercalaire thermoplastique du type PU, PVB ou EVA, sous la forme d'une structure feuilletée.

Un mode de réalisation de la présente invention est décrit par la suite, sans qu'il puisse être considéré qu'il soit limitatif de la présente invention, sous aucun des aspects décrits, en relation avec l'unique figure annexée.

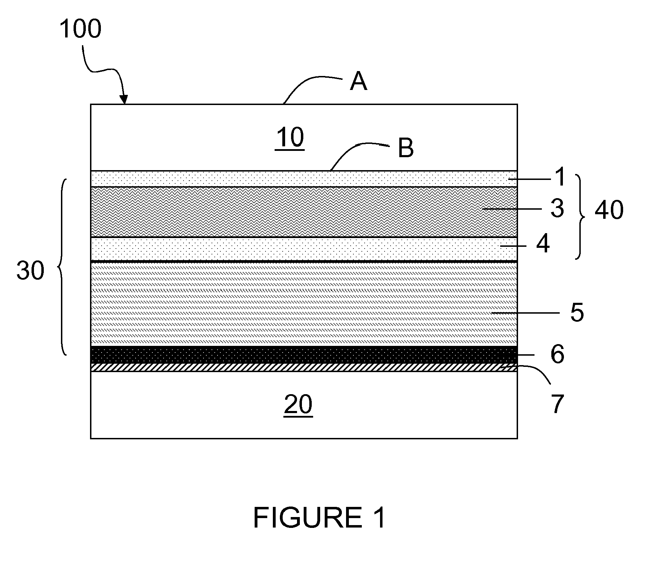

Il est représenté schématiquement sur la figure 1 une cellule photovoltaïque 100 selon la présente invention.

Cette cellule comprend en face avant, c'est-à-dire du coté exposé au rayonnement solaire, un premier substrat 10 transparent verrier dit de face avant. Ce substrat peut par exemple être entièrement dans un verre contenant des alcalins comme un verre silico-sodo-calcique.

L'essentiel de la masse (c'est-à-dire pour au moins 98 % en masse), voire la totalité du substrat à fonction verrière est de préférence constituée de matériau(x) présentant la meilleure transparence possible dans la partie du spectre solaire utile à l'application comme module solaire, c'est-à-dire généralement la partie du spectre allant d'environ 300 à environ 1300 nm. Par exemple, le substrat transparent 10 choisi selon l'invention présente une transmission élevée pour le rayonnement électromagnétique d'une longueur d'onde de 300 à 1 250 nm et en particulier pour la lumière solaire. Le substrat verrier est en général choisi pour que sa transmission, dans cette gamme, soit supérieure à 75 % et en particulier supérieure à 85 % ou même supérieur à 95%. Ce substrat est avantageusement un verre extra clair, comme le verre Diamant® commercialisé par la société SAINT-GOBAIN, ou un verre présentant des rugosités en surface, comme le verre Albarino® également commercialisé la société SAINT-GOBAIN.

Le substrat 10 peut avoir une épaisseur totale allant de 0,5 à 10 mm et est notamment utilisé comme plaque protectrice d'une cellule photovoltaïque. Il peut dans ce but être avantageux de lui faire subir au préalable un traitement thermique tel qu'une trempe.

De manière conventionnelle, on définit par A la face avant du substrat 10 dirigée vers les rayons lumineux (il s'agit de la face externe), et par B la face arrière du substrat dirigée vers le reste des couches du module solaire (il s'agit de la face interne).

La face B du substrat 10 est revêtue d'un empilement 30 de couches minces selon les modalités de l'invention.

Au moins une portion de surface du substrat est revêtue sur sa face B d'au moins une couche 1 d'un matériau connu pour ses propriétés de barrière à la diffusion des alcalins à travers les différentes couches de l'empilement 30, notamment lorsque l'ensemble est porté à haute température, par exemple lors des différentes phases de trempe ou de recuit indispensables au cours du cycle de fabrication de la cellule. La présence de cette couche barrière 1 en face B du substrat permet en particulier d'éviter, voire de bloquer, la diffusion du Na, du verre vers les couches supérieures.

Selon l'invention, la nature de cette couche n'est pas particulièrement limitée et toute couche connue à cet effet peut être utilisée selon l'invention. Notamment, cette couche barrière aux alcalins peut être à base d'un matériau diélectrique, choisi parmi les nitrures, oxydes ou oxynitrures de silicium, ou encore les nitrures, oxydes ou oxynitrures de zirconium. Il peut notamment s'agir de Si₃N₄, SiO₂, SiOₓN_{y}, TiO₂, éventuellement dopé. Parmi tout ceux-ci, le nitrure de silicium Si₃N₄ permet notamment d'obtenir un excellent effet barrière aux alcalins. Cette couche barrière aux alcalins, notamment lorsqu'elle est à base de nitrure de silicium, peut ne pas être stoechiométrique. Elle peut être de nature sous-stoechiométrique, voire sur-stoechiométrique.

La couche 1 n'est cependant pas forcément unique et il est envisagé dans le cadre de la présente invention de la remplacer par un ensemble de couches ayant cette même fonction de constituer une barrière efficace aux alcalins.

L'épaisseur de la couche barrière 1 (ou de l'ensemble des couches barrières) est comprise entre 5 et 200 nm préférentiellement comprise entre 10 et 100 nm et par exemple sensiblement voisine de 20 à 50 nm.

Sur cette couche barrière 1, on dépose une couche électroconductrice 3 selon l'invention du type « Transparent Conductive Oxide » TCO. Cette couche constitue l'électrode inférieure de la cellule photovoltaïque. Cette couche est par exemple et de préférence choisie parmi les oxydes de zinc dopés par Al, Ga, In, B, Ti, V, Y, Zr.

Cette couche conductrice est aussi transparente que possible, et présente une transmission élevée de la lumière dans l'ensemble des longueurs d'onde correspondant au spectre d'absorption du matériau constituant la couche fonctionnelle, afin de ne pas réduire inutilement le rendement du module solaire. L'épaisseur de cette couche électro-conductrice est comprise entre 50 et 1500 nm, préférentiellement comprise entre 400 et 1000 nm, et sensiblement voisine de 800-900 nm. La couche de TCO des substrats selon l'invention présente une haute conductivité électrique, une haute transparence au rayonnement électromagnétique et en particulier à la lumière solaire comme il sera décrit dans les exemples qui suivent.

Au dessus de cette couche 3 de TCO est déposée une couche tampon 4 selon l'invention, constituée par un oxyde de zinc et d'étain et/ou par un mélange d'oxydes de zinc et d'étain dont la composition globale peut être écrite Sn_{y}Zn_{z}Oₓ, la couche se caractérisant par un rapport molaire Sn/Zn (y/z) compris entre 60/40 et 85/15 et de préférence entre 65/35 et 80/20 (aussi désignée couche tampon ou couche d'oxyde zinc/étain dans la présente description).

Selon l'invention, la couche transparente d'oxyde électriquement conducteur TCO, la ou les couches protectrices et la couche tampon sont déposées successivement dans le même dispositif par les techniques connues de dépôt de couches minces sous vide, en particulier par les techniques de pulvérisation habituelles dans le domaine du dépôt des couches minces, en particulier les techniques dites pulvérisation magnétron, comme il sera plus en détail décrit par la suite.

L'empilement primaire 40 de couches minces ainsi formé est recouvert d'un film fonctionnel 5 comprenant au moins un matériau semi conducteur à base de Cadmium, comprenant notamment une hétérojonction du type CdS/CdTe, selon les techniques de dépôt bien connues, par exemple décrites dans le document US 6,169,246 B1, permettant la conversion énergétique entre les rayons lumineux et l'énergie électrique, tel que précédemment décrit.

Le film photovoltaïque 5 des cellules solaires constitué par des couches mince semi-conductrices peut utiliser une seule transition semi-conductrice (jonction simple) ou plusieurs transitions semi-conductrices (multi-jonction). Des couches semi-conductrices qui présentent la même transition interbandes, ne peuvent utiliser qu'une partie de la lumière solaire ; en revanche, des couches semi-conductrices différentes présentant différentes transitions interbandes sont sensibles un domaine étendu de longueurs d'onde de la lumière solaire.

Afin de former la seconde électrode supérieure, le film fonctionnel 5 est recouverte d'une couche conductrice 6, éventuellement transparente, de type TCO tel que précédemment décrit ou de type non transparente, comme par exemple en molybdène ou en un autre matériau métallique. En variante, cette couche électrode peut être à base d'ITO (oxyde d'indium et d'étain) ou en métal (argent, cuivre, aluminium, molybdène), en oxyde d'étain dopé au fluor ou en oxyde de zinc dopé Al.

L'ensemble de l'empilement 30 des film/couches minces 1-6 est finalement emprisonné entre le substrat de face avant 10 et un substrat de face arrière 20 sous la forme d'une structure feuilletée, par l'tampon d'un intercalaire thermoplastique 7 d'un type connu, par exemple en PU, PVB ou EVA, pour former la cellule solaire finale 100.

La cellule photovoltaïque selon l'invention telle qu'elle vient d'être décrite peut être obtenue à l'aide d'un procédé comprenant les étapes suivantes :
a) revêtir successivement et dans un même dispositif, la surface du substrat de face avant 10 par l'empilement de couches 40, comprenant la couche transparente d'oxyde électriquement conducteur la couche tampon et la ou les couches protectrices, notamment barrière aux alcalins, par la technique du dépôt sous vide par pulvérisation cathodique, éventuellement assistée par champ magnétique (dite « pulvérisation magnétron »),
b) déposer le film photovoltaïque 5 selon les techniques conventionnelles (éventuellement par la technique sous vide et dans le même dispositif),
c) déposer la couche électrode inférieure 6,
d) encapsuler l'empilement final de couches 30 entre le substrat de face avant et le substrat de face arrière par l'application du polymère thermoplastique 7, de manière à obtenir une structure feuilletée.

L'étape a), comprenant une succession dépôt sous vide par pulvérisation, est un procédé habituel et connu de réalisation de minces couches. La surface d'un corps solide de composition appropriée, appelée cible, est pulvérisée par un tir d'ions riches en énergie provenant de plasmas à basse pression, par exemple des ions d'oxygène (O⁺) et/ou des ions d'argon (Ar⁺) ou des particules neutres, suite à quoi les matériaux pulvérisés se déposent en minces couches sur les substrats (voir Römpp Online, 2008, "Sputtering"). On utilise de préférence la pulvérisation soutenue par champ magnétique, souvent appelée pulvérisation magnétron. Selon l'invention, la pression partielle d'oxygène ou d'argon peut varier largement et être ainsi aisément adaptée aux besoins de chaque cas particulier. Par exemple, les niveaux de pression partielle des gaz dans le plasma et la puissance électrique nécessaire pour la pulvérisation peuvent être définis en fonction des dimensions des substrats transparents et de l'épaisseur des couches (en particulier de TCO) à déposer. L'inconvénient de telles techniques est cependant que les couches obtenues présentent un faible taux de cristallinité des matériaux constitutifs, notamment des TCO et nécessite donc une étape de recuit pour recristalliser lesdits matériaux.

Dans un procédé selon l'invention, on réalise la pulvérisation des couches successivement dans des installations continues et déjà dimensionnée en conséquence au moyen de cibles de pulvérisation appropriées. Au cours de la première étape (a) du procédé, selon l'invention, de préférence, on utilise de préférence pour le dépôt de la couche tampon d'oxyde zinc/étain une cible d'un alliage Zinc-Etain qui présente un ratio Sn/Zn correspondant sensiblement voire exactement à celle de la couche finalement obtenue sur le substrat. Dans ce cas il est possible d'utiliser, de manière avantageuse, la technique de pulvérisation soutenue par l'action d'un champ magnétique dans une atmosphère contenant de l'oxygène, souvent appelée pulvérisation magnétron réactive.

Alternativement, il est également possible d'utiliser deux cibles dans une même chambre magnétron et d'en effectuer la pulvérisation simultanée au dessus du substrat. L'une de ces cibles est constituée de zinc métallique et l'autre d'étain métallique, les deux cibles étant simultanément pulvérisées dans une unique chambre dans une atmosphère contenant de l'oxygène, en utilisant deux générateurs DC, selon les règles de l'art. En particulier, les niveaux de pression partielle dans le plasma à basse pression et la puissance électrique nécessaire pour la pulvérisation adéquate des différentes cibles et l'obtention de la teneur souhaitée en Zinc et en Etain dans la couche tampon sont définis selon les règles de l'art, ainsi que l'épaisseur de la couche à déposer. En particulier, l'homme du métier pourra sans difficultés ajuster le réglage des différents paramètres du traitement en utilisant ses connaissances professionnelles, éventuellement en s'aidant de quelques essais d'orientation.

Les dépôts de la couche TCO et des couches à base de Cadmium constituant le film photovoltaïque sont opérés selon les techniques conventionnelles et bien connues dans le domaine, par exemple illustrées dans le brevet US 6,169,246 B1 cité précédemment.

L'électrode inférieure 6, c'est-à-dire celle tournée vers l'intérieure de la cellule par rapport au rayonnement incident, est de préférence réfléchissante dudit rayonnement. Son dépôt (étape e)) est également réalisé de manière connue par une technique de dépôt sous vide.

Enfin, au cours de l'étape f) le substrat 20 de face arrière est assemblé à l'ensemble par feuilletage au moyen d'un film en matière plastique 7 du type polyvinyl butyral (PBV) ou éthylène-vinyl-acétate (EVA) selon des techniques bien connues d'obtention d'un vitrage feuilleté.

### Exemples :

Les exemples qui suivent sont fournis pour illustrer les avantages et les propriétés améliorées des réalisations selon l'invention. Ces exemples ne doivent cependant être considérés sous aucun des aspects décrits comme limitatif de la portée de la présente invention.

Dans les exemples 1 à 5 qui suivent, on dépose sur un verre Diamant®, commercialisé par la société SAINT-GOBAIN, des couches successives selon les techniques du dépôt sous vide par magnétron. Une sous couche barrière aux alcalins en Si₃N₄, d'épaisseur 50 nm, est déposée sur le substrat verrier. Sur cette première couche barrière, une couche TCO du type AZO (oxyde mixte de ZnO dopé par 2% poids d'Al₂O₃) de 800 nanomètres d'épaisseur est déposée dans le compartiment suivant du dispositif. Des couches d'oxydes du type oxyde de zinc et d'étain sont obtenues par pulvérisation de différentes cibles en un alliage métallique de zinc et étain. Plus précisément, le dépôt des couches d'oxyde de zinc /étain a été obtenu en atmosphère oxydante faite d'un mélange Ar/O₂ et par pulvérisation de cibles métalliques comprenant un mélange de zinc et d'étain sous forme métallique, la composition du mélange étant adaptée à l'obtention des proportions molaires en Sn et Zn recherchés pour la couche tampon. L'épaisseur de la couche tampon obtenue est de l'ordre de 100 nm pour les exemples 1 à 5.

Dans tous les exemples qui suivent, la composition des couches a été mesurée par les techniques classiques de microsonde de castaing (également appelée en anglais Electron Probe Microanalyser ou EPMA).

Les caractéristiques des différents substrats, muni de l'empilement tel qu'obtenu : Verre/Si₃N₄/AZO/ Oxyde zinc-étain sont décrites dans le tableau 1 ci-dessous :

**Tableau 1**

| Echantillon | Substrat | Couche 1 (barrière aux alcalins) | Couche 2 (TCO) | Couche 3 (oxyde étain/zinc) Sn_{y}Zn_{z}O_{X} |
|---|---|---|---|---|
| Exemple 1 | Diamant | Si₃N₄ (50 nm) | AZO | SnO₂ |
| Exemple 2 (selon US 6,169,246) | Diamant | Si₃N₄ (50 nm) | AZO | SnZn₂O₄ ratio Sn/Zn = 33/66 |
| Exemple 3 | Diamant | Si₃N₄ (50 nm) | AZO | Sn_{y}Zn_{z}Oₓ (ratio Sn/Zn = 50/50) |
| Exemple 4 | Diamant | Si₃N₄ (50 nm) | AZO | Sn_{y}Zn_{z}Oₓ (ratio Sn/Zn = 75/25) |
| Exemple 5 | Diamant | Si₃N₄ (50 nm) | AZO | Pas de couche tampon |

Sur les substrats munis des empilements selon les exemples 1 à 5 on a déposé une couche de CdS par pulvérisation cathodique d'une cible de CdS dans une atmosphère d'argon comprenant 3% en volume d'oxygène, jusqu'à atteindre une épaisseur de 125 nm de CdS. Une couche de CdTe est ensuite déposée au dessus de la couche de Cds selon les techniques classiques de sublimation en espace clos, sous une atmosphère de 16 Torr (2100 Pa) d'hélium, sous une température de 500°C. La durée effective du dépôt est de 2 minutes.

La couche ainsi déposée est ensuite soumise à un traitement thermique de recuit sous une atmosphère de CdCl₂ à 415°C pendant 5 minutes.

Une électrode arrière est formée à partir d'une pâte de graphite dopée par HgTe est brossée sur la couche de CdTe puis un recuit est effectué à 230°C pendant 25 minutes. Finalement, une pate d'argent est brossée sur la couche de graphite et un recuit final est effectué sur l'ensemble à 130°C pendant une durée effective d'une heure.

Les caractéristiques propres de la cellule ainsi obtenue, selon le modèle d'un circuit électrique équivalent pour une cellule solaire ou « solar cell equivalent » circuit selon le terme anglais, sont mesurées selon les paramètres habituels:
- Jsc : c'est la valeur en mA/cm² de densité de courant générée par le module solaire, à zéro volt (c'est-à-dire la densité de courant correspondant à un court circuit),
- Voc : c'est l'abréviation anglaise pour « open circuit voltage », c'est-à-dire la tension (en volts) en circuit ouvert,
- FF (%) : c'est l'abréviation anglaise pour le paramètre « Fill Factor », qui est défini comme la puissance maximale de la cellule divisée par la valeur de Jsc et de Voc,
- eff (%) : c'est l'efficacité solaire de la cellule, définie comme le pourcentage de puissance convertie (et collectée) à partir de la lumière absorbée pour une cellule solaire raccordée au circuit électrique. Ce terme est calculé en faisant le ratio du point de puissance maximum Pm par le produit de l'irradiance de la lumière incidente (E en W/m²) sous des conditions standard et la surface de la cellule solaire (en m²). Les conditions standards signifient une température de 25°C et une irradiance de 1000 W/m² selon le spectre AM1.5.

Les résultats obtenus pour les exemples 1 à 5 sont regroupés dans le tableau 2 qui suit :

**Tableau 2**

| | eff (%) | FF (%) | JSC (mA/cm²) | Voc (V) |
|---|---|---|---|---|
| Cellule selon exemple 1 | 7,9 | 56 | 20,0 | 701 |
| Cellule selon exemple 2 | 8,9 | 61 | 21,8 | 672 |
| Cellule selon exemple 3 | 8,6 | 56 | 20,9 | 733 |
| Cellule selon exemple 4 | 10,9 | 65 | 21,3 | 790 |
| Cellule selon exemple 5 | 8,2 | 59 | 19,2 | 728 |

Les résultats indiqués dans le tableau 2 indiquent clairement que les cellules munies des couches tampons selon l'exemple 4 entre la couche de TCO et le film photovoltaïque présentent des performances supérieures, notamment un rendement sensiblement supérieur, aux autres cellules testées, et notamment celles connues de l'art antérieur.

Dans un deuxième temps, d'autres cellules identiques à celle de l'exemple 4 précédent ont été synthétisées selon les mêmes méthodes que précédemment exposées. L'empilement de couches est identique à celui de l'exemple 4 mais on a fait varier l'épaisseur de la couche tampon dans les proportions reportées dans le tableau 3 qui suit. Pour chacune de ces cellules, l'efficacité solaire à été mesurée selon les principes précédemment exposés :

**Tableau 3**

| Echantillon | Substrat | Couche 3 (Sn_{y}Zn_{Z}O_{X}) ratio Sn/Zn (y/z) | Epaisseur de la couche | Eff(%) |
|---|---|---|---|---|
| Exemple 6 | Diamant | 75/25 | 75 nm | 11,0 |
| Exemple 7 | Diamant | 75/25 | 100 nm | 10,9 |
| Exemple 8 (selon l'invention) | Diamant | 75/25 | 150 n m | 12,3 |
| Exemple 9 (selon l'invention) | Diamant | 75/25 | 200 nm | 12,5 |
| Exemple 10 | Diamant | 75/25 | 300 nm | 10,5 |

De façon étonnante, on voit sur les données reportées dans le tableau 3 que l'épaisseur de la couche tampon influe fortement sur l'efficacité finale de la cellule. Une gamme d'épaisseur très réduite, de l'ordre de 150 à 200 nm, donne les meilleurs résultats en termes d'efficacité de la cellule photovoltaïque.

## Revendications

1. Cellule photovoltaïque (100) comprenant au moins un substrat transparent de face avant (10) notamment verrier, protégeant un empilement de couches (30) comprenant un film à propriétés photovoltaïques (5), et deux électrodes inférieure (3) et supérieure (6), disposées de part et d'autre dudit film photovoltaïque (5), l'électrode inférieure (3), c'est-à-dire la plus proche du substrat de face avant (10), étant constituée par un revêtement du type oxyde transparent conducteur TCO, ladite cellule **se caractérisant :**
- **en ce que** ledit oxyde transparent conducteur est un oxyde de zinc dopé par au moins un élément choisi parmi Al, Ga, In, B, Ti, V, Y, Zr,
- **en ce qu'**une couche tampon est interposée entre ledit TCO et ledit film photovoltaïque, ladite couche tampon présentant les caractéristiques suivantes :
- elle est constituée par un oxyde ou par un mélange d'oxydes de zinc et d'étain dans lequel le rapport molaire Sn/Zn est compris entre 60/40 et 85/15,
- elle présente une épaisseur comprise entre 150 et 200 nm.

2. Cellule photovoltaïque selon la revendication 1 dans lequel ledit film à propriétés photovoltaïques incorpore au moins un matériau comprenant du Cadmium.

3. Cellule photovoltaïque selon la revendication 2, dans laquelle ledit film photovoltaïque comprend une hétérojonction du type CdS/CdTe.

4. Cellule photovoltaïque selon la revendication 1 dans lequel ledit film à propriétés photovoltaïques incorpore au moins un matériau du type séléniure.

5. Cellule photovoltaïque selon la revendication 4 dans lequel ledit film à propriétés photovoltaïques incorpore au moins un matériau du type CIS (Cuivre Indium Sélénium) ou CIGS (Cuivre Indium Sélénium Gallium).

6. Cellule photovoltaïque selon l'une des revendications précédentes, dans laquelle ledit oxyde transparent conducteur TCO est l'oxyde de zinc dopé à l'aluminium, au gallium ou au bore, de préférence l'oxyde de zinc dopé à l'aluminium.

7. Cellule photovoltaïque selon l'une des revendications précédentes, dans laquelle la couche de TCO présente une épaisseur comprise entre 50 et 1600 nm, de préférence entre 500 et 1500 nm.

8. Cellule photovoltaïque selon l'une des revendications précédentes, dans laquelle la couche tampon est constituée par un oxyde ou par un mélange d'oxydes de zinc et d'étain dans lequel le rapport molaire Sn/Zn est compris entre 70/30 et 85/15.

9. Cellule photovoltaïque selon l'une des revendications, comprenant en outre une couche de nitrure de gallium ou d'aluminium entre ladite couche TCO et ladite couche tampon.

10. Cellule photovoltaïque selon l'une des revendications précédentes, dans laquelle la couche tampon est déposée par les techniques de pulvérisation magnétique magnétron à partir d'une cible métallique comprenant un alliage de zinc et d'étain dans une atmosphère contenant de l'oxygène.

11. Cellule photovoltaïque selon l'une des revendications 1 à 10, dans laquelle la couche tampon est déposée par les techniques de co-pulvérisation magnétique magnétron d'une cible en zinc métallique et d'une cible en étain métallique, dans une atmosphère contenant de l'oxygène.

12. Cellule photovoltaïque selon l'une des revendications précédentes, comprenant :
- un premier substrat verrier, dont la transmission lumineuse dans la gamme de longueur d'onde de 300 à 1 250 nm est supérieure à 75%, de préférence supérieure à 85%,
- un empilement comprenant au moins, en succession depuis la surface dudit premier substrat verrier :
o une couche d'oxyde transparent conducteur en oxyde de zinc dopé à l'aluminium, au gallium ou au bore,
o une couche tampon constituée par un oxyde ou un mélange d'oxyde dans laquelle le rapport molaire Sn/Zn est compris entre 60/40 et 85/15, de préférence entre 70/30 et 85/15,
o un film photovoltaïque de préférence comprenant du cadmium ou du sélénium,
o une couche conductrice (6) transparente du type TCO ou non transparente, en molybdène ou en un autre matériau métallique du type argent, cuivre, aluminium, molybdène,
- un second substrat verrier, collé au premier substrat, revêtu de l'empilement, par un intercalaire thermoplastique (7) du type PU, PVB ou EVA, sous la forme d'une structure feuilletée.
